# EUROPÄISCHE PATENTSCHRIFT

(11) **EP 3 231 002 B1**
(45) Veröffentlichungstag und Bekanntmachung des Hinweises auf die Patenterteilung: **22.05.2019**
(21) Anmeldenummer: 15813239.9
(22) Anmeldetag: 09.12.2015
(51) Int. Cl.: H01J 37/18

(54) **ELEKTRONENMIKROSKOP UND VERFAHREN ZUM UNTERSUCHEN EINER PROBE MIT EINEM ELEKTRONENMIKROSKOP**
ELECTRON MICROSCOPE AND METHOD FOR EXAMINING A SAMPLE USING AN ELECTRON MICROSCOPE
MICROSCOPE ÉLECTRONIQUE ET PROCÉDÉ POUR EXAMINER UN ÉCHANTILLON À L'AIDE D'UN MICROSCOPE ÉLECTRONIQUE

(30) Priorität: 10.12.2014 AT 508972014
(43) Veröffentlichungstag der Anmeldung: 18.10.2017
(73) Patentinhaber: Verein Zur Förderung Der Elektronenmikroskopie Und Feinstrukturforschung, 8010 Graz (AT)
(72) Erfinder: RATTENBERGER, Johannes, 8054 Graz (AT); FITZEK, Harald Matthias, 8010 Graz (AT); WAGNER, Julian, 1190 Wien (AT); SCHRÖTTNER, Hartmuth, 8055 Graz (AT)
(74) Vertreter: Wirnsberger & Lerchbaum Patentanwälte OG
(86) Internationale Anmeldenummer: PCT/AT2015/050309
(87) Internationale Veröffentlichungsnummer: WO 2016/090398

(56) Entgegenhaltungen:
- EP-A2- 0 196 958
- WO-A1-2010/035265
- JP-A- S5 676 151

## Beschreibung

Die Erfindung betrifft ein Elektronenmikroskop, umfassend eine Elektronenquelle zum Erzeugen eines Elektronenstrahls, eine Elektronensäule, durch welche der Elektronenstrahl auf eine in einer Probenkammer auf einem Probentisch angeordnete Probe trifft, zumindest eine endseitig an der Elektronensäule angeordnete druckbegrenzende Blende und einen Detektor zum Detektieren von niederenergetischen Elektronen.

Weiter betrifft die Erfindung eine Verwendung eines solchen Elektronenmikroskops.

Darüber hinaus betrifft die Erfindung ein Verfahren zum Untersuchen einer Probe mit einem Elektronenmikroskop, wobei von einer Elektronenquelle ein Elektronenstrahl erzeugt wird, welcher durch eine Elektronensäule und zumindest eine druckbegrenzende Blende auf die in einer Probenkammer an einem Probentisch angeordnete Probe geleitet wird, von welcher Sekundärelektronen und Rückstreuelektronen erzeugt werden, wobei niederenergetische Elektronen von einem Detektor detektiert werden.

Aus dem Stand der Technik ist ein Environmental Scanning Electron Microscope (ESEM) bekannt geworden. Dabei handelt es sich um eine spezielle Ausführungsvariante eines Rasterelektronenmikroskops (REM), mit welchem im Gegensatz zu diesem auch eine feuchte Probe ohne präparativen Aufwand derselben untersuchbar ist. Im Unterschied zum REM, in welchem neben einem Druck in der Elektronensäule auch dieser in der Probenkammer üblicherweise bis zu einem Hoch- bzw. Ultrahochvakuum erniedrigt ist, ist in der Probenkammer des ESEMs ein höherer Druck vorgesehen. Wie beim REM wird auch beim ESEM eine in der Probenkammer befindliche Probe mit einem fokussierten Elektronenstrahl aus Primärelektronen abgerastert, wobei von dieser durch Wechselwirkung mit den Primärelektronen Sekundärelektronen erzeugt werden und deren verstärktes Signal von einem Detektor detektiert wird. Die Sekundärelektronen werden durch Stoßionisation mit Gasatomen verstärkt und vom positiv geladenen Detektor angezogen, wobei auch eine große Menge an positiv geladenen Gasatomen bzw. Gasmolekülen erzeugt wird. Dies ist maßgeblich dafür, dass in einem ESEM eine elektrisch nicht leitende Probe untersuchbar ist, da die positiv geladenen Gasatome bzw. Gasmoleküle an der Oberfläche der Probe rekombinieren und dadurch eine negative Aufladung der Probe verhindern bzw. neutralisieren.

Allerdings ist auch der Druck in der Probenkammer eines ESEMs nicht beliebig hoch einstellbar. Je höher dieser Druck ist, desto weniger Primärelektronen des Elektronenstrahls kommen im fokussierten Punkt auf der Probenoberfläche an, da die Primärelektronen vorher durch das Gas in der Probenkammer gestreut werden, wodurch auch weniger Sekundärelektronen in einem vom Elektronenstrahl fokussierten Punkt erzeugt werden. Die durch das Gas gestreuten Primärelektronen erzeugen in anderen Bereichen der Probe Sekundärelektronen, was unerwünscht ist. Darüber hinaus nimmt auch eine Ionisation bzw. Verstärkung von im fokussierten Punkt erzeugten Sekundärelektronen mit steigendem Druck immer mehr ab. Durch diesen dreifach negativen Effekt, dass zum einen wenig Sekundärelektronen im fokussierten Punkt erzeugt werden, welche auch noch schlechter verstärkt werden und zum anderen auch in nicht fokussierten Punkten Sekundärelektronen erzeugt werden, nimmt ein Signal-Rausch-Verhältnis in einem erzeugten Bild der Probe bzw. Probenoberfläche mit steigendem Druck in der Probenkammer beträchtlich ab. Aktuell wird ein ESEM üblicherweise bei einem Druck größer als 800 Pa, aus oben genannten Gründen jedoch nur bis zu einem Druck von etwa 2000 Pa betrieben bzw. eine Probenkammer bis zu etwa 2000 Pa evakuiert bzw. gepumpt. Zusätzlich wird die zu untersuchende Probe oftmals auf etwa 4 °C gekühlt, um ein Ausgasen einer biologischen Probe zumindest teilweise zu verhindern. Um eine Probe in einem ESEM zu untersuchen, muss die Probenkammer also immer zumindest auf einen erniedrigten Druck gepumpt werden, was auch eine Veränderung der Probe durch den erniedrigten Druck zur Folge haben kann. Es ist folglich mit einem aus dem Stand der Technik bekannten ESEM nicht möglich, unbehandelte biologische Proben unter naturbelassenen Umgebungsbedingungen zu untersuchen.

Aufgabe der Erfindung ist es, ein Elektronenmikroskop der eingangs genannten Art anzugeben, bei welchem es möglich ist, insbesondere eine unbehandelte Probe bei offener Probenkammer in diese zu legen und mit welchem auch dynamische Experimente durchführbar sind.

Weiter ist es Ziel der Erfindung, eine Verwendung eines solchen Elektronenmikroskops anzugeben.

Ein weiteres Ziel der Erfindung ist es, ein Verfahren der eingangs genannten Art anzugeben, bei welchem insbesondere unbehandelte Proben bei offener Probenkammer eines Elektronenmikroskops in diese gelegt werden und diese auch *in situ* untersucht werden können.

Die Aufgabe wird erfindungsgemäß dadurch gelöst, dass bei einem Elektronenmikroskop der eingangs genannten Art die Elektronensäule entlang deren Längsachse mit konstantem oder sich zur Probenkammer hin verjüngendem freien Durchmesser und relativ zum Probentisch sowie unabhängig vom Detektor verfahrbar ausgebildet ist, sodass die Probe unter Atmosphärendruck und/oder bei Raumtemperatur untersuchbar ist.

Ein mit der Erfindung erzielter Vorteil ist insbesondere darin zu sehen, dass durch die Ausbildung der Elektronensäule sowie deren Verfahrbarkeit relativ zum Probentisch und unabhängig vom Detektor die Probe optimal zur Elektronensäule bzw. zur druckbegrenzenden Blende positionierbar ist, sodass eine zurückzulegende Wegstrecke des Elektronenstrahls durch das Gas in der Probenkammer minimiert ist. Dadurch tritt nur ein geringer Anteil der Primärelektronen mit dem Gas der Probenkammer in Wechselwirkung und ein Großteil der Primärelektronen des Elektronenstrahls trifft ungestreut auf die Probe. Der Elektronenstrahl aus Primärelektronen ist also scharf auf einen gewünschten Punkt der Probe fokussierbar, wodurch einerseits die meisten Primärelektronen ungestreut auf diesen Punkt treffen und andererseits in diesem fokussierten Punkt eine große Anzahl von Sekundärelektronen erzeugbar ist. Neben den Sekundärelektronen werden von der Probe durch Streuung der Primärelektronen an bzw. in der Probe auch Rückstreuelektronen mit einer kleinen mittleren freien Weglänge erzeugt. Dabei ist die mittlere freie Weglänge indirekt proportional zu einer Energie der Elektronen. Bei hohem Druck in der Probenkammer werden diese Rückstreuelektronen durch Stoßprozesse mit Gasteilchen abgebremst und in weiterer Folge durch Stoßionisation rund um den Detektor verstärkt. Weiter lösen die Rückstreuelektronen durch Stoßprozesse Sekundärelektronen im Gas aus. Diese Signale der nun niederenergetischen Elektronen sind neben dem verstärkten Signal der Sekundärelektronen ebenfalls vom Detektor detektierbar, wobei auch die Sekundärelektronen rund um den Detektor verstärkt werden. Allgemein gilt, dass eine Energie der Elektronen, welche vom Detektor detektierbar sind, von einer an diesem angelegten Spannung abhängt bzw. kleiner als diese sein muss. Es kann vorgesehen sein, dass eine Detektorspannung in einem Bereich von etwa 500 V bis 1000 V, bevorzugt in einem Bereich von 600 V bis 750 V, liegt. Ein Druck in der Elektronensäule ist dabei in der Regel um ein Vielfaches niedriger als in der Probenkammer (bevorzugt etwa Atmosphärendruck) wobei die unterschiedlichen Druckbereiche in der Elektronensäule und in der Probenkammer von der druckbegrenzenden Blende abgetrennt sind. Erfindungsgemäß ist die Elektronensäule bevorzugt länglich ausgebildet. Mit einem erfindungsgemäßen Elektronenmikroskop sind insbesondere auch feuchte bzw. biologische Proben bei Raumtemperatur untersuchbar. Darüber hinaus ist eine Probe nicht nur bei Raumtemperatur untersuchbar, sondern kann auch bei offener Probenkammer in einfacher Weise in diese gelegt werden. Natürlich ablaufende Prozesse sind ohne Beeinflussung durch einen erniedrigten Druck und/oder erniedrigte Temperatur beobachtbar bzw. die Probenoberfläche abbildbar.

Mit Vorteil ist dabei der Detektor außerhalb der Elektronensäule, insbesondere von der druckbegrenzenden Blende entkoppelt, angeordnet. Dadurch ist einerseits gewährleistet, dass in der Elektronensäule möglichst ausschließlich Primärelektronen vorhanden sind, und andererseits die Probe beliebig zur Elektronensäule bzw. druckbegrenzenden Blende positionierbar ist, um eine Wechselwirkung der Primärelektronen mit dem Abbildungsgas zu vermeiden. Der Detektor ist dabei mit Vorteil so ausgebildet, dass mit diesem alle niederenergetischen Elektronen detektierbar sind. Detektiert werden dabei ein verstärktes Signal von Sekundärelektronen, ein verstärktes Signal von abgebremsten Rückstreuelektronen und ein Signal der durch die Rückstreuelektronen im Abbildungsgas ausgelösten Sekundärelektronen.

Vorteilhaft ist weiter der Detektor in der Probenkammer am Probentisch angeordnet, wobei der Probentisch verfahrbar ist. Der Detektor wird mit dem Probentisch derart verfahren, dass möglichst viele niederenergetische Elektronen auf diesen treffen. Der Probentisch kann in beliebig vielen Achsen verfahrbar sein, günstig ist es jedoch, wenn dieser zumindest in einer Achse, bevorzugt in zwei Achsen verfahrbar ist, um die Probe optimal zu positionieren. Eine erste Achse kann dabei in Richtung der Elektronensäule und eine zweite Achse etwa senkrecht dazu verlaufen.

Bevorzugt ist dabei vorgesehen, dass der Detektor als Nadeldetektor mit vorbestimmtem Spitzenradius ausgebildet ist. Am Nadeldetektor ist eine Spannung angelegt, welche ein elektrisches Feld erzeugt und die niederenergetischen Elektronen zu diesem hin beschleunigt. Dabei gilt, dass je kleiner der Spitzenradius des Nadeldetektors ist, desto stärker ist die elektrische Feldstärke des elektrischen Feldes und umso stärker werden die niederenergetischen Elektronen verstärkt bis diese auf den Detektor treffen. Dadurch ist die Verstärkung des Signals von niederenergetischen Elektronen rund um den Detektor maximiert und das Signal-Rausch-Verhältnis optimiert.

Dabei kann es günstig sein, wenn ein Spitzenradius des Nadeldetektors kleiner als 100 µm, bevorzugt kleiner als 50 µm, insbesondere kleiner als 10 µm, ist. Insbesondere für Messungen unter Atmosphärendruck sollte der Spitzenradius des Nadeldetektors möglichst klein sein, um zu erreichen, dass eine genügend hohe Anzahl von niederenergetischen Elektronen auf den Detektor trifft bzw. von diesem angezogen wird. Erfindungsgemäß kann vorgesehen sein, dass ein Spitzenradius des Nadeldetektors für Atmosphärendruck in der Probenkammer etwa 5 µm oder kleiner, insbesondere etwa 0,5 µm, ist. Bei einem mit kleinem Spitzenradius ausgebildeten Detektor kann zudem die an diesem angelegte Spannung gering sein, wodurch Spannungsüberschläge im Gas in der Probenkammer vermeidbar sind.

Mit Vorteil kann weiter vorgesehen sein, dass der Detektor in einer gesondert evakuierbaren Detektorkammer angeordnet ist. In der Detektorkammer herrscht dabei in der Regel ein geringerer Druck als in der Probenkammer, was dazu führt, dass die Verstärkung der niederenergetischen Elektronen zum Detektor hin weiter optimiert und somit das Signal-Rausch-Verhältnis zusätzlich verbessert ist. Die Detektorkammer kann bevorzugt bis zu einem Druck im Bereich von etwa 400 Pa bis 1200 Pa, insbesondere im Bereich von etwa 800 Pa bis 1000 Pa, evakuierbar sein und ist derart ausgebildet, dass diese eine Öffnung umfasst, durch welche die niederenergetischen Elektronen zum Detektor gelangen.

Vorteilhaft ist es, wenn die zumindest eine druckbegrenzende Blende insbesondere waagrecht ausgerichtet an einem unteren Ende der Elektronensäule angeordnet ist. Dadurch ist sichergestellt, dass bei einem hohen Druck in der Probenkammer der Druck in der Elektronensäule trotzdem im Hoch- bzw. Ultrahochvakuumbereich gehalten werden kann. Dabei entspricht Hochvakuum einem Druckbereich zwischen 0,1 Pa und 10⁻⁵ Pa und Ultrahochvakuum einem Druckbereich zwischen 10⁻⁵ Pa und 10⁻¹⁰ Pa. Durch die druckbegrenzende Blende ist eine scharfe Abgrenzung der Elektronensäule zur Probenkammer geschaffen, sodass nur möglichst wenig Gas von dieser in die Elektronensäule gelangt. Weiter ist es durch die Bauweise und die Ausrichtung der druckbegrenzende Blende möglich, selbst bei hohem Druck in der Probenkammer noch genug Primärelektronen ungestreut auf eine Probe zu leiten, um in weiterer Folge genügend Sekundärelektronen und dadurch ein Bild der Probe bzw. Probenoberfläche mit gutem Signal-Rausch-Verhältnis zu erzeugen.

Günstig ist es dabei, wenn die zumindest eine druckbegrenzende Blende entlang deren Längsachse zumindest einen Bereich mit einem sich verjüngenden freien Durchmesserumfasst, wobei eine Stelle mit einem kleinsten Durchmesser in Richtung der Probenkammer ausgerichtet ist. Durch diese spezielle Ausbildung der druckbegrenzenden Blende ist gewährleistet, dass ein Druckgradient zwischen Elektronensäule und Probenkammer groß genug ist, um einen Gaseintritt von der Probenkammer in die Elektronensäule möglichst zu vermeiden. Darüber hinaus wird der Elektronenstrahl durch die druckbegrenzende Blende möglichst exakt auf einen vorbestimmten Punkt der Probe bzw. Probenoberfläche fokussiert. Vorteilhaft kann bei der Ausbildung der druckbegrenzenden Blende sein, wenn ein Öffnungswinkel der Blende möglichst groß ist. Durch den Öffnungswinkel bzw. den sich verjüngenden freien Durchmesser des Bereiches ist sichergestellt, dass so wenig Gas wie möglich in die Elektronensäule gelangt. Es kann auch vorgesehen sein, dass die druckbegrenzende Blende einen, zwei oder mehr Bereiche mit sich verjüngenden freien Durchmessern und einen weiteren Bereich mit einem konstanten Durchmesser umfasst. Bei einer Ausführung der druckbegrenzenden Blende mit drei Bereichen ist der freie Durchmesser des am oberen Ende der druckbegrenzenden Blende angeordneten ersten Bereiches größer als jener des mittig angeordneten zweiten Bereiches, wobei ein Übergang zwischen den beiden Bereichen bevorzugt sprunghaft erfolgt bzw. in einer Ebene. Dabei kann vorgesehen sein, dass ein Winkel der sich verjüngenden Bohrung des endseitigen Bereiches etwa 70° beträgt und jener des mittig angeordneten Bereiches etwa 90°. Maße bzw. Abmessungen des mittig angeordneten Bereiches scheinen dabei entscheidend für den Druckgradienten zu sein. Dieser Bereich kann dafür etwa 120 µm oder weniger dick bzw. hoch sein, wobei die gesamte druckbegrenzende Blende dabei etwa 270 µm oder weniger dick bzw. hoch sein kann. Erfindungsgemäß kann weiter vorgesehen sein, dass die druckbegrenzende Blende einen durchgängig konstanten freien Durchmesser aufweist, sofern dies für eine bestimmte Messung günstig zu sein scheint. Durch die besondere Ausführung der druckbegrenzenden Blende sowie deren Anordnung an der Elektronensäule ist es nicht nur möglich, einen Druckgradienten zwischen der Elektronensäule und der Probenkammer zu maximieren, sondern es ist darüber hinaus in Kombination mit der Ausbildung der Elektronensäule auch ein Sichtfeld groß genug gehalten.

Vorteilhaft ist weiter eine zweite druckbegrenzende Blende vorgesehen, welche an einem oberen Ende der Elektronensäule angeordnet ist, wobei die Elektronenquelle außerhalb der Elektronensäule in einer von dieser gesondert evakuierbaren Kammer angeordnet ist. Dadurch ist der Vakuumbereich in der Elektronensäule auch nach oben hin begrenzt und sichergestellt, dass die Primärelektronen des Elektronenstrahls möglichst fokussiert und ungestreut auf die Probe treffen. Ein Druck in der Kammer mit der Elektronenquelle kann bevorzugt der am meisten erniedrigte Druck des gesamten Elektronenmikroskops sein. Dieser kann bis zu einem Hochvakuum oder Ultrahochvakuum erniedrigt sein, wobei dazu zumindest eine Vakuumpumpe vorgesehen ist. Dadurch werden einerseits Überschläge vermieden und andererseits die Primärelektronen möglichst ungestreut beschleunigt. Erfindungsgemäß kann auch vorgesehen sein, dass die zweite druckbegrenzende Blende entsprechend der ersten druckbegrenzenden Blende ausgebildet ist. Möglich ist es jedoch auch, dass diese mit einem durchgängig konstanten freien Durchmesser ausgebildet ist. Erfindungsgemäß kann es günstig sein, wenn beide druckbegrenzenden Blenden endseitig, aber innerhalb der Elektronensäule angeordnet sind. Erfindungsgemäß kann in der Kammer weiter ein Linsensystem vorgesehen sein, welche den Elektronenstrahl fokussiert.

Besonders bevorzugt ist dabei zumindest eine Vakuumpumpe vorgesehen, mit welcher bei gleichzeitigem Atmosphärendruck in der Probenkammer ein Druck in der Elektronensäule bis zu einem Hochvakuum, insbesondere bis zu einem Ultrahochvakuum, erniedrigbar ist, wobei die druckbegrenzende Blende derart ausgebildet ist, dass ein Druckübergang sprunghaft erfolgt. Dadurch wird ein maximaler Druckgradient zwischen Elektronensäule und Probenkammer erreicht. Durch die druckbegrenzende Blende ist die Elektronensäule scharf von der Probenkammer abgegrenzt und der Elektronenstrahl trifft fokussiert auf die Probe. Auch eine Streuung der Primärelektronen ist dadurch derart verringert, dass in weiterer Folge eine Bildgebung möglich ist. Es kann weiter zumindest eine zusätzliche Vakuumpumpe vorgesehen sein, um gegebenenfalls den Druck in der Probenkammer bis zu einem vorbestimmten Wert zu erniedrigen. In der Probenkammer kann sich alternativ zu Umgebungsluft auch Wasserdampf oder ein anderes beliebiges Gas befinden.

Eine Verwendung eines erfindungsgemäßen Elektronenmikroskops erfolgt mit Vorteil beim Untersuchen einer insbesondere feuchten und/oder biologischen Probe unter Atmosphärendruck und/oder bei Raumtemperatur.

Das weitere Ziel wird erfindungsgemäß erreicht, wenn bei einem Verfahren der eingangs genannten Art der Elektronenstrahl durch eine Elektronensäule mit einem entlang deren Längsachse konstanten oder sich zur Probenkammer hin verjüngenden freien Durchmesser zur Probe geleitet wird, welche relativ zum Probentisch sowie unabhängig vom Detektor verfahren wird, um die Probe bevorzugt unter Atmosphärendruck und/oder bei Raumtemperatur zu untersuchen.

Bei einem erfindungsgemäßen Verfahren wird nur ein geringer Anteil bzw. deutlich weniger als bei einem aus dem Stand der Technik bekannten Verfahren der Primärelektronen des Elektronenstrahls im Gas in der Probenkammer gestreut und somit treffen viele Elektronen in einem fokussierten Punkt auf die Probe bzw. Probenoberfläche. Hierfür wird ein Abstand zwischen Probe und Elektronensäule bzw. druckbegrenzender Blende derart eingestellt, dass eine zurückzulegende Wegstrecke der Primärelektronen minimiert wird, wobei ein Minimalabstand zwischen Probe und Elektronensäule etwa dem Durchmesser der druckbegrenzenden Blende entsprechen kann. Dadurch ist eine Probe auch unter Atmosphärendruck untersuchbar. Allgemein gilt, je mehr Primärelektronen auf einen fokussierten Punkt der Probe treffen, umso mehr Sekundärelektronen werden in diesem Punkt erzeugt. Durch die Einstellbarkeit der Elektronensäule relativ zum Probentisch sowie unabhängig vom Detektor werden die von der Probe bzw. Probenoberfläche in dem vom Elektronenstrahl fokussierten Punkt erzeugten Sekundärelektronen sowie die durch Streuung der Primärelektronen an der Probenoberfläche erzeugten und durch Stoßprozesse abgebremsten Rückstreuelektronen und die durch die Rückstreuelektronen im Gas erzeugten Sekundärelektronen auf den Detektor geleitet bzw. von diesem angezogen. Diese nun niederenergetischen Elektronen werden rund um den Detektor verstärkt und von diesem detektiert, wodurch ein Bild der Probe erzeugt wird. Eine am Detektor angelegte Spannung kann dabei gering gehalten werden, um Spannungsüberschläge im Gas der Probenkammer zu vermeiden. Die Detektorspannung kann dabei in einem Bereich von 500 V bis 1000 V, bevorzugt in einem Bereich von etwa 600 V bin 750 V, liegen. Eine Energie der detektierbaren niederenergetischen Elektronen muss dabei geringer sein als die Detektorspannung, um von diesem detektiert werden zu können. Weiter können die einzelnen Bestandteile des Elektronenmikroskops und die Probe derart zueinander eingestellt werden, dass im fokussierten Punkt möglichst viele Sekundärelektronen erzeugt und positiv geladene Atome bzw. Moleküle ionisiert werden.

Vorteilhaft ist dabei vorgesehen, dass die niederenergetischen Elektronen von einem als Nadeldetektor mit vorbestimmtem Spitzenradius ausgebildeten und von der druckbegrenzenden Blende entkoppelt unterhalb dieser angeordneten Detektor detektiert werden. Insbesondere kann dabei vorgesehen sein, dass der Detektor am Probentisch angeordnet wird, wobei eine Spannung an diesem angelegt wird. Je kleiner der Spitzenradius des Nadeldetektors ausgebildet ist, desto größer ist die elektrische Feldstärke im Bereich des Nadeldetektors und umso mehr niederenergetische Elektronen werden rund um diesen verstärkt. Insbesondere unter Atmosphärendruck ist es zweckmäßig, den Spitzenradius des Detektors so auszubilden, dass damit ein großes elektrisches Feld rund um den Detektor erzeugt wird, ohne dass die am Detektor angelegte Spannung erhöht werden muss. Eine zu hohe angelegte Spannung verursacht nämlich unerwünschte elektrische Überschläge im Gas in der Probenkammer. Erfindungsgemäß kann dabei vorgesehen sein, dass der Spitzenradius des Nadeldetektors kleiner als 100 µm, bevorzugt kleiner als 50 µm, insbesondere kleiner als 10 µm, ist. Der Nadeldetektor wird dabei derart positioniert, dass genügend niederenergetische Elektronen auf diesen treffen, um ein Bild der Probe mit einem großen Signal-Rausch-Verhältnis zu erzeugen.

Günstig ist es dabei, wenn eine Detektorkammer zur Lagerung des Detektors gesondert evakuiert wird. Dabei kann vorgesehen sein, dass ein Druck in der Detektorkammer niedriger gehalten wird als ein Druck in der Probenkammer. Durch die Erniedrigung des Druckes in der Detektorkammer ist die Verstärkung des Signals der niederenergetischen Elektronen zum Detektor besser, wodurch das Signal-Rausch-Verhältnis optimiert wird. Die Detektorkammer wird dabei mit Vorteil bis zu einem Druck im Bereich von etwa 400 Pa bis 1200 Pa, insbesondere im Bereich von etwa 800 Pa bis 1000 Pa, evakuiert. Weiter ist diese mit einer Öffnung ausgebildet, durch welche die niederenergetischen Elektronen vom geladenen Detektor angezogen werden und auf diesen treffen.

Mit Vorteil kann weiter vorgesehen sein, dass der Probentisch mit der Probe bis zu einem vorbestimmten Abstand zur druckbegrenzenden Blende hin verfahren wird. Die Elektronensäule kann dabei ortsfest angeordnet sein. Ein Abstand zwischen Probe und druckbegrenzender Blende wird dabei derart gewählt, dass einerseits eine Wegstrecke des Elektronenstrahls durch die Probenkammer minimiert und andererseits ein Sichtfeld groß genug gehalten wird. Dazu kann ein Minimalabstand zwischen der Probe und der druckbegrenzenden Blende etwa so groß sein wie ein Durchmesser der druckbegrenzenden Blende. Zusätzlich zur Bewegungsrichtung in Richtung der druckbegrenzenden Blende bzw. der Elektronensäule können weitere Bewegungsrichtungen des Probentisches vorgesehen sein, z. B. kann dieser etwa senkrecht zur ersten Bewegungsrichtung verfahren werden, um die Probe optimal zu positionieren.

Vorteilhaft ist es, wenn die Elektronensäule und die Probenkammer durch die zumindest eine druckbegrenzende, insbesondere waagrecht angeordnete druckbegrenzende Blende abgetrennt werden. Die druckbegrenzende Blende ist dabei bevorzugt derart ausgebildet, dass ein Druckgradient zwischen Elektronensäule und Probenkammer maximiert wird und somit so wenig Gas wie möglich in die Elektronensäule gelangt. Dadurch ist weiter sichergestellt, dass möglichst viele Primärelektronen des Elektronenstrahls ungestreut auf die Probe treffen. Je mehr Primärelektronen auf einen fokussierten Punkt der Probe gelangen, umso mehr Sekundärelektronen werden in diesem Punkt erzeugt, welche anschließend in der Gasumgebung der Probenkammer verstärkt und vom Detektor angezogen werden. Zusätzlich werden auch alle anderen niederenergetischen Elektronen wie z. B. durch Stoßprozesse abgebremste Rückstreuelektronen von der Gasumgebung der Probenkammer verstärkt und vom Detektor angezogen bzw. detektiert. Dadurch wird ein Bild der Probe mit hohem Signal-Rausch-Verhältnis erzeugt.

Bevorzugt ist weiter vorgesehen, dass der von der Elektronenquelle erzeugte Elektronenstrahl über eine zweite druckbegrenzende Blende in die Elektronensäule geleitet wird, wobei eine Kammer mit der Elektronenquelle gesondert von der Elektronensäule evakuiert wird. Dies erlaubt es, die Drücke unabhängig voneinander einzustellen, um eine Fokussierung des Elektronenstrahls zu maximieren. Die Kammer wird bevorzugt bis zu einem Ultrahochvakuum oder Hochvakuum evakuiert.

Besonders günstig ist es dabei, wenn ein Druck in der Elektronensäule erniedrigt wird, bevorzugt bis zu einem Hochvakuum, insbesondere bis zu einem Ultrahochvakuum, und die Probenkammer unter Atmosphärendruck gehalten wird, um den Druck sprunghaft zu ändern und somit den Druckgradienten zwischen Elektronensäule und Probenkammer zu maximieren. Dadurch kann eine Probe unter Atmosphärendruck und/oder bei Raumtemperatur untersucht und dabei einfach in die Probenkammer gelegt werden. Erfindungsgemäß kann als Gas in der Probenkammer Luft oder Wasserdampf vorgesehen sein. Es kann jedoch auch für bestimmte Messungen zweckmäßig sein, wenn zumindest eine Vakuumpumpe vorgesehen ist, mit welcher der Druck in der Probenkammer bis zu einem vorbestimmten Wert erniedrigt wird.

Weitere Merkmale, Vorteile und Wirkungen ergeben sich aus den nachfolgend dargestellten Ausführungsbeispielen. In den Zeichnungen, auf welche dabei Bezug genommen wird, zeigen:
Fig. 1 einen schematischen Schnitt durch ein erfindungsgemäßes Elektronenmikroskop;
Fig. 2 einen schematischen Schnitt durch ein weiteres erfindungsgemäßes Elektronenmikroskop;
Fig. 3 einen schematischen Schnitt durch ein weiteres erfindungsgemäßes Elektronenmikroskop;
Fig. 4 einen Schnitt durch eine druckbegrenzende Blende eines erfindungsgemäßen Elektronenmikroskops;
Fig. 5 einen Schnitt durch eine weitere druckbegrenzende Blende eines erfindungsgemäßen Elektronenmikroskops;
Fig. 6 einen Schnitt durch eine weitere druckbegrenzende Blende eines erfindungsgemäßen Elektronenmikroskops.

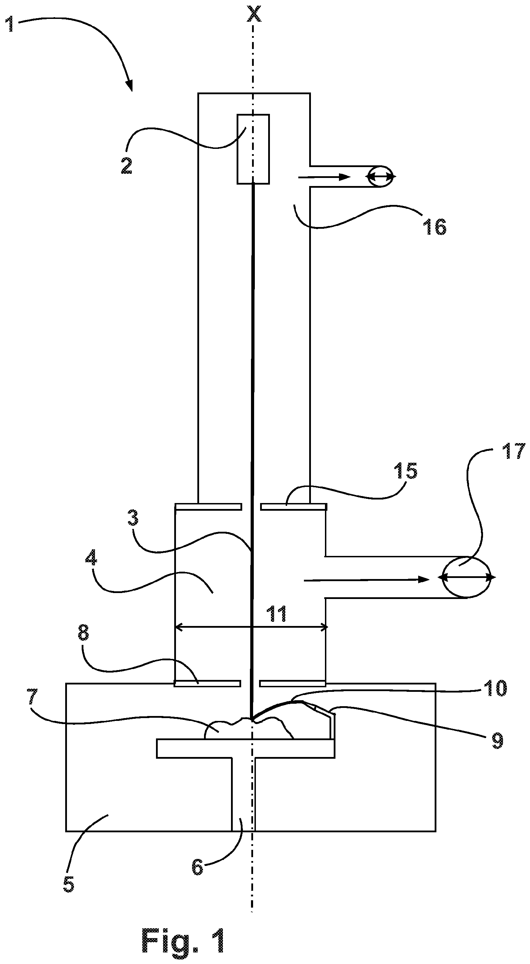

Fig. 1 zeigt einen schematischen Schnitt durch ein erfindungsgemäßes Elektronenmikroskop 1, umfassend eine Elektronenquelle 2 zum Erzeugen eines Elektronenstrahls 3 und eine Elektronensäule 4, durch welche der Elektronenstrahl 3 auf eine Probe 7 trifft. Die Probe 7 ist dabei in einer Probenkammer 5 auf einem Probentisch 6 angeordnet. Vorteilhaft kann dabei vorgesehen sein, dass der Probentisch 6 mit der Probe 7 verfahrbar ist. Von Vorteil ist dieser zumindest in zwei Achsen verfahrbar, mindestens aber in einer Achse parallel zu einer Längsachse X der Elektronensäule 4. Die zweite Achse kann dabei eine senkrecht zur ersten Achse stehenden Achse sein, um ein optimales Positionieren der Probe 7 zu ermöglichen. Es kann jedoch auch vorgesehen sein, dass die Elektronensäule 4 verfahrbar ist, um diese relativ zur Probe 7 zu bewegen, bevorzugt entlang deren Längsachse X.

Wie in Fig. 1 dargestellt, ist die Elektronensäule 4 durch eine druckbegrenzende Blende 8 von der Probenkammer 5 abgetrennt. Die druckbegrenzende Blende 8 kann dabei bevorzugt derart ausgebildet sein, dass ein Druckgradient zwischen der Elektronensäule 4 und der Probenkammer 5 maximiert ist. Dadurch ist es möglich, die Probenkammer 5 unter Atmosphärendruck zu halten und somit auch eine feuchte Probe 7 zu untersuchen. Weiter ist ein Detektor 9 vorgesehen, welcher wie in Fig. 1 dargestellt bevorzugt als Nadeldetektor ausgebildet sein kann. Vorteilhaft ist dieser in der Probenkammer 5 am Probentisch 6 angeordnet, insbesondere von der druckbegrenzenden Blende 8 entkoppelt. Erfindungsgemäß kann auch zumindest eine in Fig. 1 nicht dargestellte Vakuumpumpe vorgesehen sein, welche einen Druck in der Probenkammer 5 bis zu einem vorbestimmten Druckbereich pumpt bzw. evakuiert.

Die Elektronenquelle 2 ist bevorzugt in einer evakuierbaren Kammer 16 gelagert, in welcher beispielsweise ein Druck bis zu einem Ultrahochvakuum oder Hochvakuum erniedrigt ist. Auch die Elektronensäule 4 ist mit zumindest einer Vakuumpumpe 17 evakuierbar, wobei ein Druck in dieser bevorzugt bis zu einem Hochvakuum (Druckbereich zwischen 0,1 Pa und 10⁻⁵ Pa), insbesondere bis zu einem Ultrahochvakuum (Druckbereich zwischen 10⁻⁵ Pa und 10⁻¹⁰ Pa), erniedrigt ist. In der Kammer 16 kann bevorzugt ein nicht dargestelltes Linsensystem angeordnet sein, um den Elektronenstrahl 3 zu fokussieren. Zwischen der Kammer 16 und der Elektronensäule 4 ist zu deren Abtrennung eine zweite druckbegrenzende Blende 15 vorgesehen, durch welche Primärelektronen des Elektronenstrahls 3 in die Elektronensäule 4 gelangen, wonach diese durch die erste druckbegrenzende Blende 8 hindurch auf die Probe 7 bzw. einen fokussierten Punkt auf der Probenoberfläche treffen. Dort wechselwirken die Primärelektronen mit der Probe 7 bzw. Probenoberfläche und erzeugen im fokussierten Punkt Sekundärelektronen. Ein Signal von verstärkten Sekundärelektronen und ein Signal von durch Stoßprozesse abgebremste sowie verstärkte Rückstreuelektronen und durch Rückstreuelektronen im Gas erzeugte Sekundärelektronen werden vom Detektor 9 als niederenergetische Elektronen 10 detektiert.

In Fig. 1 ist die Elektronensäule 4 mit einem entlang deren Längsachse X konstanten freien Durchmesser 11 ausgebildet. Die an die Elektronensäule 4 anschließende druckbegrenzende Blende 8 ist dabei etwa waagrecht ausgerichtet und schließt somit einen Winkel von etwa 90° mit der Elektronensäule 4 ein.

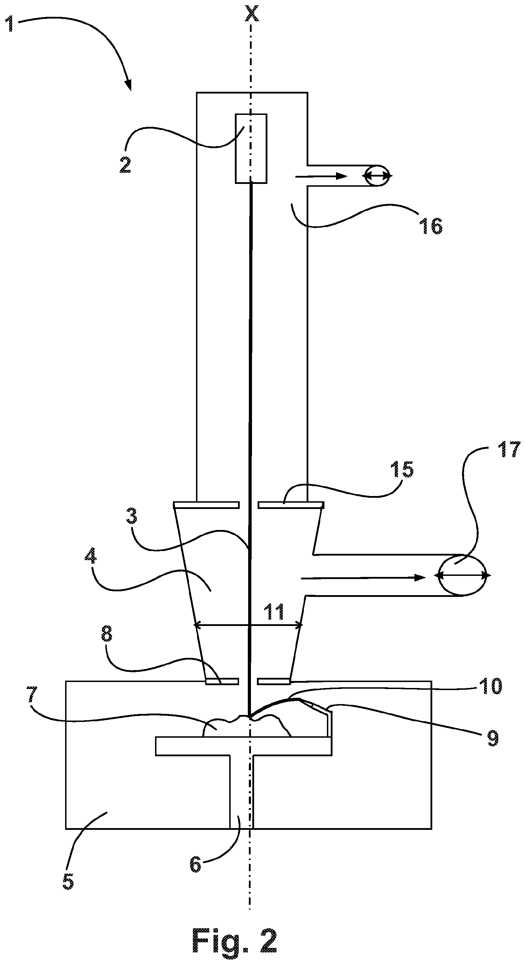

Im Gegensatz dazu umfasst ein erfindungsgemäßes Elektronenmikroskop 1 gemäß Fig. 2 eine Elektronensäule 4 mit einem entlang deren Längsachse X sich zur Probenkammer 5 hin verjüngenden freien Durchmesser 11. Dies ermöglicht eine noch bessere Abtrennung der beiden Druckbereiche in der Elektronensäule 4 und in der Probenkammer 5. Zu beachten ist jedoch dabei, dass ein innerer Winkel zwischen Elektronensäule 4 und Probenkammer 5 nicht zu groß ist, damit ein Sichtfeld nicht zu sehr eingeschränkt wird.

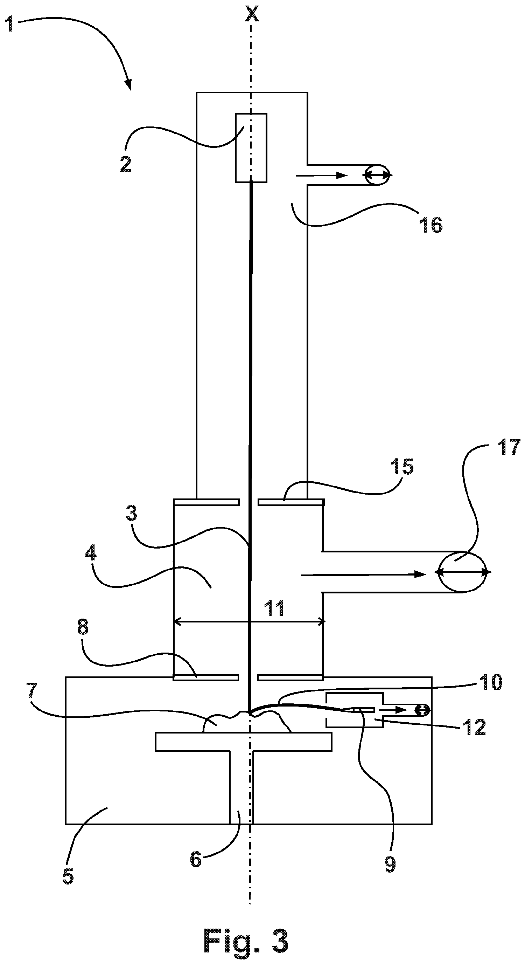

In Fig. 3 ist ein schematischer Schnitt durch ein weiteres erfindungsgemäßes Elektronenmikroskop 1 dargestellt. Dabei ist der Detektor 9 in einer gesondert evakuierbaren Detektorkammer 12 gelagert, welche üblicherweise mit zumindest einer zusätzlichen Vakuumpumpe bis zu einem vorbestimmten Druck gepumpt wird. Dadurch herrscht im Bereich einer Detektion geringerer Druck als in der Probenkammer 5 selbst und eine Verstärkung des Signals der niederenergetischen Elektronen 10 ist maximiert, was in weiterer Folge zu einem optimierten Signal-Rausch-Verhältnis führt. Der Druck in der Detektorkammer 12 kann dabei in einem Bereich von etwa 400 Pa bis etwa 1200 Pa liegen. Auch bei einem Elektronenmikroskop 1 gemäß Fig. 2 kann vorgesehen sein, dass der Detektor 9 in einer gesondert evakuierbaren Detektorkammer 12 gelagert ist. Darüber hinaus kann auch bei diesem Elektronenmikroskop 1 zumindest eine Vakuumpumpe zum Evakuieren der Probenkammer vorgesehen sein.

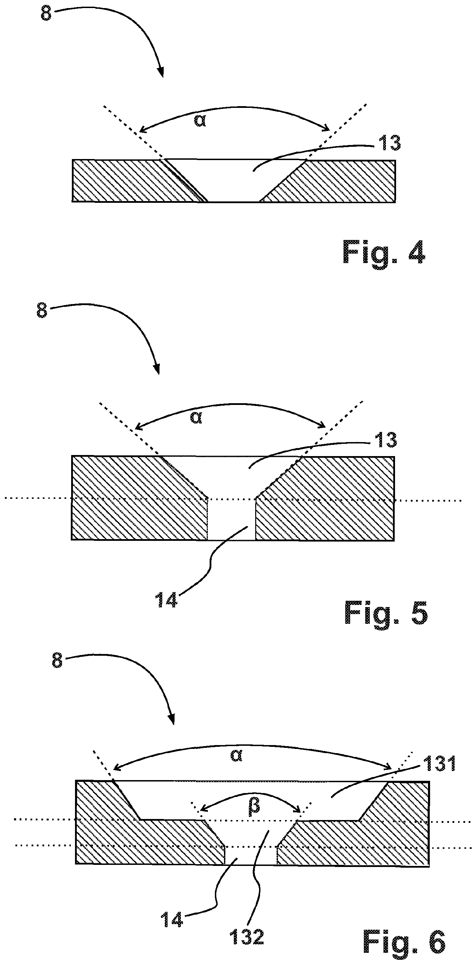

Fig. 4 zeigt einen Schnitt durch eine druckbegrenzende Blende 8 eines erfindungsgemäßen Elektronenmikroskops 1, umfassend einen Bereich 13 mit einem sich verjüngendem freien Durchmesser, wobei die druckbegrenzende Blende 8 so im Elektronenmikroskop 1 angeordnet wird, dass der kleinste Durchmesser in Richtung der Probenkammer 5 ausgerichtet ist. Der sich verjüngende freie Durchmesser bzw. ein Öffnungswinkel α der druckbegrenzenden Blende 8 kann dabei etwa 90° sein. Allgemein gilt jedoch, je größer der Öffnungswinkel ist, umso besser ist eine Abtrennung der Elektronensäule 4 von der Probenkammer 5. Darüber hinaus ist die druckbegrenzende Blende 8 möglichst dünn ausgebildet. Diese kann beispielsweise aus einer Goldfolie gebildet sein und somit eine Dicke von nur wenigen µm aufweisen. Es scheint, dass je dünner die druckbegrenzende Blende 8 und je größer der Öffnungswinkel α des Bereiches 13 ist, umso größer ein Druckgradient zwischen zwei Bereichen mit unterschiedlichen Drücken.

In Fig. 5 ist ein Schnitt durch eine weitere druckbegrenzende Blende 8 eines erfindungsgemäßen Elektronenmikroskops 1 gezeigt. Diese druckbegrenzende Blende 8 kann dabei bevorzugt derart ausgebildet sein, dass diese zwei Bereiche 13, 14 umfasst. Die unterbrochene Linie in Fig. 4 zeigt dabei eine fiktive Grenze zwischen diesen beiden Bereichen 13, 14. Dabei ist ein oberer Bereich 13 entlang einer Längsachse der druckbegrenzenden Blende 8 mit einem sich verjüngenden freien Durchmesser und ein unterer Bereich 14 mit einem konstanten freien Durchmesser ausgebildet. Der konstante freie Durchmesser des unteren Bereiches 14 kann dabei etwa 50 µm bis 300 µm betragen. Die druckbegrenzende Blende 8 ist optimiert, um einen möglichst großen Druckgradienten zwischen Elektronensäule 4 und Probenkammer 5 zu erzeugen. Der obere Bereich 13 der druckbegrenzenden Blende 8 kann etwa 10 µm bis 300 µm, bevorzugt etwa 100 µm hoch bzw. dick sein. Ein Öffnungswinkel α der sich verjüngenden Bohrung bzw. des freien Durchmessers des oberen Bereiches 13 kann dabei bevorzugt etwa 90° betragen.

Ein Schnitt durch eine weitere druckbegrenzende Blende 8 eines erfindungsgemäßen Elektronenmikroskops 1 ist in Fig. 6 dargestellt. Diese druckbegrenzende Blende 8 umfasst zwei obere Bereiche 131, 132 mit sich verjüngenden freien Durchmessern und einen unteren Bereich 14 mit einem konstanten Durchmesser. Dabei ist der freie Durchmesser des am oberen Ende der druckbegrenzenden Blende 8 ersten oberen Bereiches 131 größer als jener des mittig angeordneten zweiten oberen Bereiches 132, wobei ein Übergang zwischen den beiden oberen Bereichen 131, 132 bevorzugt sprunghaft erfolgt bzw. mit einer Geraden dargestellt ist. Fiktive Abtrennungen der Bereiche 131, 132, 14 sind dabei wieder durch unterbrochene Linien dargestellt. Es kann vorgesehen sein, dass ein Öffnungswinkel α der sich verjüngenden Bohrung des endseitigen ersten oberen Bereiches 131 etwa 70° beträgt und ein Öffnungswinkel β des mittig angeordneten zweiten oberen Bereiches 132 etwa 90°. Bei einer druckbegrenzenden Blende 8 gemäß Fig. 6 scheinen Abmessungen des mittig angeordneten zweiten oberen Bereiches 132 entscheidend zu sein. Dieser Bereich 132 kann dafür z. B. etwa 120 µm oder weniger dick bzw. hoch sein, wobei die gesamte druckbegrenzende Blende 8 dabei etwa 270 µm oder weniger dick bzw. hoch sein kann. Mit dieser druckbegrenzenden Blende 8 ist ein Druckgradient zwischen der Elektronensäule 4 und der Probenkammer 5 nochmals erhöht. Vorgesehen sein kann weiter, dass die druckbegrenzende Blende 8 mehr als zwei obere Bereiche 131, 132 umfasst. Bei allen Varianten der druckbegrenzenden Blende 8 mit zwei oder mehr Bereichen 131, 132, 14 ist bei einer Befestigung der druckbegrenzenden Blende 8 in einem Elektronenmikroskop 1 jeweils der untere Bereich 14 mit dem konstanten freien Durchmesser in Richtung der Probenkammer 5 und der erste obere Bereich 131 in Richtung der Elektronensäule 4 ausgerichtet.

Die zweite druckbegrenzende Blende 15 kann der ersten druckbegrenzenden Blende 8 entsprechend ausgebildet sein. Erfindungsgemäß kann jedoch auch vorgesehen sein, dass diese einen durchgängig konstanten freien Durchmesser aufweist. Die zweite druckbegrenzende Blende 15 trennt dabei die Kammer 16, welche bevorzugt bis zu einem Feinvakuum gepumpt wird, von der Elektronensäule 4 ab, in welcher Hoch- bzw. Ultrahochvakuum herrscht. Erfindungsgemäß kann weiter vorgesehen sein, dass auch die erste druckbegrenzende Blende 8 eine Bohrung mit einem durchgängig konstanten Durchmesser aufweist.

Erfindungsgemäß können darüber hinaus mehrere austauschbare druckbegrenzende Blenden 8, 15 vorgesehen sein, welche jeweils unterschiedliche Abmessungen aufweisen, abhängig davon, welche Anforderungen diese erfüllen sollen. Dabei kann das Elektronenmikroskop 1 derart ausgebildet sein, dass die druckbegrenzenden Blenden 8, 15 in einfacher Weise austauschbar sind. Beispielsweise können die druckbegrenzenden Blenden 8, 15 jeweils kraftschlüssig mit z. B. einem Sprengring angebracht bzw. gesichert sein. Alternativ kann auch vorgesehen sein, dass zumindest eine der beiden druckbegrenzenden Blenden 8, 15 stoffschlüssig fixiert ist, z. B. geklebt. Die druckbegrenzenden Blenden 8, 15 können erfindungsgemäß aus einem Metall oder einer Metalllegierung gebildet sein, beispielsweise aus Platin, Tantal oder Titan.

Bei einem erfindungsgemäßen Verfahren zum Untersuchen einer Probe 7 mit einem Elektronenmikroskop 1 wird die Probe 7 bei offener Probenkammer 5 auf den darin angeordneten Probentisch 6 gelegt. Erfindungsgemäß kann dabei vorgesehen sein, dass die Probenkammer 5 nicht gepumpt, also unter Atmosphärendruck gehalten wird. Alternativ kann aber auch zumindest eine weitere Vakuumpumpe zum Erniedrigen des Druckes in der Probenkammer 5 an diese angeschlossen werden. Weiter kann vorgesehen sein, dass die Probe 7 zusätzlich oder alternativ nicht gekühlt, sondern bei Raumtemperatur untersucht wird. Der Probentisch 6 wird mit der Probe 7 bis zu einem vorbestimmten Anstand in Richtung Elektronensäule 4 verfahren. Erfindungsgemäß kann dieser auch in noch zumindest eine weitere Richtung verfahren werden.

Zum Erstellen eines Bildes der Probe 7 bzw. Probenoberfläche wird in einem ersten Schritt von der Elektronenquelle 2 über ein nicht dargestelltes Linsensystem ein fokussierter Elektronenstrahl 3 aus Primärelektronen erzeugt, welcher über die zweite druckbegrenzende Blende 15 in die Elektronensäule 4 geleitet wird. Die zweite druckbegrenzende Blende 15 trennt die Kammer 16, welche üblicherweise von zumindest einer weiteren Vakuumpumpe bis zu einem Hochvakuum oder Ultrahochvakuum evakuiert bzw. gepumpt wird, von der Elektronensäule 4 ab, welche von der zumindest einen Vakuumpumpe 17 bis zu einem Hochvakuum oder Ultrahochvakuum evakuiert bzw. gepumpt wird. Die Elektronensäule 4 wird nach unten hin mit der druckbegrenzenden Blende 8 begrenzt, um das Hoch- bzw. Ultrahochvakuum in dieser nicht mit Gas zu verunreinigen. Beim Auftreffen der Primärelektronen des Elektronenstrahls 3 auf der Probe 7 werden von dieser durch Wechselwirkungen mit den Primärelektronen Sekundärelektronen und Rückstreuelektronen erzeugt. Die Rückstreuelektronen verlieren durch Stoßprozesse mit dem Gas in der Probenkammer 5 Energie und werden wie die Sekundärelektronen im Abblidungsgas ionisiert und zum positiv geladenen Detektor 9 hin beschleunigt. Gleichzeitig werden bei diesen Stoßprozessen Sekundärelektronen im Gas gebildet, welche ebenfalls zum Detektor 9 hin beschleunigt werden. Es wird also das Signal aller niederenergetische Elektronen 10 zum Detektor 9 hin verstärkt und von diesem detektiert. Der Detektor 9, welcher bevorzugt als Nadeldetektor ausgebildet sein kann, ist positiv geladen, um die niederenergetischen Elektronen 10 anzuziehen. Dabei gilt, dass je kleiner ein Spitzenradius des Nadeldetektors ist, umso größer ist eine elektrische Feldstärke, was dazu führt, dass das Signal der niederenergetischen Elektronen 10 rund um den Nadeldetektor verstärkt wird. Durch die Spitze des Nadeldetektors wird also ein Gradient im elektrischen Feld realisiert. Wenn der Spitzenradius klein genug ist, kann eine am Nadeldetektor angebrachte Spannung gering gehalten werden, wodurch Spannungsüberschläge vermieden werden.

Erfindungsgemäß kann auch vorgesehen sein, dass der Detektor 9 in einer Detektorkammer 12 gelagert wird, welche gesondert und unabhängig von der Probenkammer 5 von zumindest einer weiteren Vakuumpumpe evakuiert wird. Dabei wird der Druck in der Detektorkammer 12 üblicherweise niedriger gehalten als in der Probenkammer 5. Dies hat den Vorteil, dass eine Verstärkung der niederenergetischen Elektronen 10 bzw. deren Signal zum Detektor 9 hin nochmals erhöht und somit ein größeres Signal-Rausch-Verhältnis erzeugt wird. Der Detektor 9 kann dabei beliebig ausgebildet sein, vorteilhaft ist dieser jedoch wiederum als Nadeldetektor ausgebildet.

Ein erfindungsgemäßes Elektronenmikroskop 1 kann in mehreren technischen Bereichen eingesetzt werden, beispielsweise in der Halbleiterindustrie. Dabei kann dieses zwischen zwei Produktionsschritten platziert werden, um ein Bauteil auf dessen Qualität zu prüfen, ohne dass dafür ein evakuierter Bereich notwendig ist.

## Patentansprüche

1. Elektronenmikroskop (1), umfassend eine Probenkammer (5), eine Elektronenquelle (2) zum Erzeugen eines Elektronenstrahls (3), eine Elektronensäule (4), durch welche der Elektronenstrahl (3) auf eine in der Probenkammer (5) auf einem Probentisch (6) angeordnete Probe (7) trifft, zumindest eine endseitig an der Elektronensäule (4) angeordnete druckbegrenzende Blende (8) und einen in der Probenkammer angeordneten Detektor (9) zum Detektieren von niederenergetischen Elektronen (10), wobei die Elektronensäule (4) entlang deren Längsachse (X) mit konstantem oder sich zur Probenkammer (5) hin verjüngendem freien Durchmesser (11) ausgebildet ist, **dadurch gekennzeichnet, dass** die Elektronensäule (4) relativ zum Probentisch (6) sowie unabhängig vom Detektor (9) verfahrbar ausgebildet ist, sodass die Probe (7) unter Atmosphärendruck und/oder bei Raumtemperatur untersuchbar ist.

2. Elektronenmikroskop (1) nach Anspruch 1, **dadurch gekennzeichnet, dass** der Detektor (9) außerhalb der Elektronensäule (4), insbesondere von der druckbegrenzenden Blende (8) entkoppelt, angeordnet ist.

3. Elektronenmikroskop (1) nach Anspruch 1 oder 2, **dadurch gekennzeichnet, dass** der Detektor (9) in der Probenkammer (5) am Probentisch (6) angeordnet ist, wobei der Probentisch (6) verfahrbar ist.

4. Elektronenmikroskop (1) nach einem der Ansprüche 1 bis 3, **dadurch gekennzeichnet, dass** der Detektor (9) als Nadeldetektor mit vorbestimmtem Spitzenradius ausgebildet ist.

5. Elektronenmikroskop (1) nach Anspruch 4, **dadurch gekennzeichnet, dass** ein Spitzenradius des Nadeldetektors kleiner als 100 µm, bevorzugt kleiner als 50 µm, insbesondere kleiner als 10 µm, ist.

6. Elektronenmikroskop (1) nach einem der Ansprüche 1 bis 5, **dadurch gekennzeichnet, dass** der Detektor (9) in einer gesondert evakuierbaren Detektorkammer (12) angeordnet ist.

7. Elektronenmikroskop (1) nach einem der Ansprüche 1 bis 6, **dadurch gekennzeichnet, dass** die zumindest eine druckbegrenzende Blende (8) insbesondere waagrecht ausgerichtet an einem unteren Ende der Elektronensäule (4) angeordnet ist.

8. Elektronenmikroskop (1) nach einem der Ansprüche 1 bis 7, **dadurch gekennzeichnet, dass** die zumindest eine druckbegrenzende Blende (8) entlang deren Längsachse zumindest einen Bereich (13) mit einem sich verjüngenden freien Durchmesser umfasst.

9. Elektronenmikroskop (1) nach einem der Ansprüche 1 bis 8, **dadurch gekennzeichnet, dass** eine zweite druckbegrenzende Blende (15) vorgesehen ist, welche an einem oberen Ende der Elektronensäule (4) angeordnet ist, wobei die Elektronenquelle (2) außerhalb der Elektronensäule (4) in einer von dieser gesondert evakuierbaren Kammer (16) angeordnet ist.

10. Elektronenmikroskop (1) nach einem der Ansprüche 1 bis 9, **dadurch gekennzeichnet, dass** zumindest eine Vakuumpumpe (17) vorgesehen ist, mit welcher bei gleichzeitigem Atmosphärendruck in der Probenkammer (5) ein Druck in der Elektronensäule (4) bis zu einem Hochvakuum, insbesondere bis zu einem Ultrahochvakuum, erniedrigbar ist, wobei die Blende (8) so ausgebildet ist, dass ein Druckübergang sprunghaft erfolgt.

11. Verwendung eines Elektronenmikroskops (1) nach einem der Ansprüche 1 bis 10 zum Untersuchen einer insbesondere feuchten und/oder biologischen Probe (7) unter Atmosphärendruck und/oder bei Raumtemperatur.

12. Verfahren zum Untersuchen einer Probe (7) mit einem Elektronenmikroskop (1), wobei von einer Elektronenquelle (2) ein Elektronenstrahl (3) erzeugt wird, welcher durch eine Elektronensäule (4) und zumindest eine druckbegrenzende Blende (8) auf die in einer Probenkammer (5) an einem Probentisch (6) angeordnete Probe (7) geleitet wird, von welcher Sekundärelektronen und Rückstreuelektronen erzeugt werden, wobei niederenergetische Elektronen (10) von einem in der Probenkammer angeordneten Detektor (9) detektiert werden, **dadurch gekennzeichnet, dass** der Elektronenstrahl (3) durch eine Elektronensäule (4) mit einem entlang deren Längsachse (X) konstanten oder sich zur Probenkammer (5) hin verjüngenden freien Durchmesser (11) zur Probe (7) geleitet wird, welche relativ zum Probentisch (6) sowie unabhängig vom Detektor (9) verfahren wird, um die Probe (7) bevorzugt unter Atmosphärendruck und/oder bei Raumtemperatur zu untersuchen.

13. Verfahren nach Anspruch 12, **dadurch gekennzeichnet, dass** die niederenergetischen Elektronen (10) von einem als Nadeldetektor mit vorbestimmtem Spitzenradius ausgebildeten und von der druckbegrenzenden Blende (8) entkoppelt unterhalb dieser angeordneten Detektor (9) detektiert werden.

14. Verfahren nach Anspruch 12 oder 13, **dadurch gekennzeichnet, dass** eine Detektorkammer (12) zur Lagerung des Detektors (9) gesondert evakuiert wird.

15. Verfahren nach einem der Ansprüche 12 bis 14, **dadurch gekennzeichnet, dass** der Probentisch (6) mit der Probe (7) bis zu einem vorbestimmten Abstand zur druckbegrenzenden Blende (8) hin verfahren wird.

## Claims

1. Electron microscope (1), comprising a sample chamber (5), an electron source (2) for generating an electron beam (3), an electron column (4), by means of which the electron beam (3) impinges on a sample (7) arranged on a sample table (6) in the sample chamber (5), at least one pressure-limiting screen (8) arranged at an end of the electron column (4), and a detector (9), arranged in the sample chamber (5), for detecting low-energy electrons (10), wherein the electron column (4) is designed along its longitudinal axis (X) with a free diameter (11) which is constant or tapering towards the sample chamber (5), **characterized in that** the electron column (4) is designed to be movable relative to the sample table (6) and independently of the detector (9), so that the sample (7) can be examined under atmospheric pressure and/or at room temperature.

2. Electron microscope (1) according to claim 1, **characterized in that** the detector (9) is arranged outside the electron column (4), in particular decoupled from the pressure-limiting screen (8).

3. Electron microscope (1) according to claim 1 or 2, **characterized in that** the detector (9) is arranged in the sample chamber (5) on the sample table (6), wherein the sample table (6) is movable.

4. Electron microscope (1) according to any one of claims 1 to 3, **characterized in that** the detector (9) is designed as a needle detector with predefined tip radius.

5. Electron microscope (1) according to claim 4, **characterized in that** a tip radius of the needle detector is less than 100 µm, preferably less than 50 µm, in particular less than 10 µm.

6. Electron microscope (1) according to any one of claims 1 to 5, **characterized in that** the detector (9) is arranged in a detector chamber (12) which can be separately evacuated.

7. Electron microscope (1) according to any one of claims 1 to 6, **characterized in that** the at least one pressure-limiting screen (8) is oriented in particular horizontally at a lower end of the electron column (4) .

8. Electron microscope (1) according to any one of claims 1 to 7, **characterized in that** the at least one pressure-limiting screen (8) comprises at least one region (13) with a tapering free diameter along its longitudinal axis.

9. Electron microscope (1) according to any one of claims 1 to 8, **characterized in that** a second pressure-limiting screen (15) is provided, which is arranged at an upper end of the electron column (4), wherein the electron source (2) is arranged outside the electron column (4) in a chamber (16) which can be evacuated separately from the latter.

10. Electron microscope (1) according to any one of claims 1 to 9, **characterized in that** at least one vacuum pump (17) is provided, with which under simultaneous atmospheric pressure in the sample chamber (5) a pressure in the electron column (4) can be lowered to a high vacuum, in particular to an ultra-high vacuum, wherein the screen (8) is designed such that a pressure transition takes place abruptly.

11. Use of an electron microscope (1) according to any one of claims 1 to 10 for examining an in particular moist and/or biological sample (7) under atmospheric pressure and/or at room temperature.

12. Method for examining a sample (7) with an electron microscope (1), wherein an electron source (2) generates an electron beam (3) which is directed by means of an electron column (4) and at least one pressure-limiting screen (8) onto the sample (7) arranged in a sample chamber (5) on a sample table (6), from which secondary electrons (10) and backscattered electrons are generated, wherein low-energy electrons (10) are detected by a detector (9) arranged in the sample chamber, **characterized in that** the electron beam (3) is directed to the sample (7) by means of an electron column (4) with a free diameter (11), which is constant or tapering towards the sample chamber (5) along its longitudinal axis (X), which sample is moved relative to the sample table (6) and independently of the detector (9) in order to examine the sample (7) under atmospheric pressure and/or at room temperature.

13. Method according to claim 12, **characterized in that** the low-energy electrons (10) are detected by a detector (9), which is designed as a needle detector with predefined tip radius and decoupled from and arranged underneath the pressure-limiting screen (8).

14. Method according to claim 12 or 13, **characterized in that** a detector chamber (12) for mounting the detector (9) is separately evacuated.

15. Method according to any of claims 12 to 14, **characterized in that** the sample table (6) with the sample (7) is moved up to a predefined distance from the pressure-limiting screen (8).

## Revendications

1. Microscope électronique (1), comprenant une chambre à échantillon (5), une source d'électrons (2) pour générer un rayon électronique (3), une colonne électronique (4) à travers laquelle le rayon électronique (3) arrive sur un échantillon (7) disposé dans la chambre à échantillon (5) sur une table à échantillon (6), au moins un écran (8) limitant la pression disposé à l'extrémité de la colonne électronique (4) et un détecteur (9) disposé dans la chambre à échantillon pour la détection d'électrons à basse énergie (10), la colonne électronique (4) étant réalisée le long de son axe longitudinal (X) avec un diamètre (11) constant ou se rétrécissant en direction de la chambre à échantillon (5), **caractérisé en ce que** la colonne électronique (4) est réalisée de manière à être déplaçable par rapport à la table à échantillon (6) et indépendamment du détecteur (9), de sorte que l'échantillon (7) peut être analysé sous pression atmosphérique et/ou à température ambiante.

2. Microscope électronique (1) selon la revendication 1, **caractérisé en ce que** le détecteur (9) est disposé à l'extérieur de la colonne électronique (4) en particulier en étant dissocié de l'écran de limitation de pression (8).

3. Microscope électronique (1) selon la revendication 1 ou 2, **caractérisé en ce que** le détecteur (9) est disposé dans la chambre à échantillon (5) sur la table à échantillon (6), la table à échantillon (6) étant déplaçable.

4. Microscope électronique (1) selon une des revendications 1 à 3, **caractérisé en ce que** le détecteur (9) est réalisé sous forme d'un détecteur à aiguille avec un rayon de pointe prédéfini.

5. Microscope électronique (1) selon la revendication 4, **caractérisé en ce qu'**un rayon de pointe du détecteur à aiguilles est inférieur à 100 µm, de préférence inférieur à 50 µm, en particulier inférieur à 10 µm.

6. Microscope électronique (1) selon une des revendications 1 à 5, **caractérisé en ce que** le détecteur (9) est disposé dans une chambre à détecteur (12) pouvant être mise sous vide séparément.

7. Microscope électronique (1) selon une des revendications 1 à 6, **caractérisé en ce que** l'au moins un écran de limitation de pression (8) est disposé en particulier en orientation horizontale à une extrémité inférieure de la colonne électronique (4).

8. Microscope électronique (1) selon une des revendications 1 à 7, **caractérisé en ce que** l'au moins un écran de limitation de pression (8) comprend, le long de son axe longitudinal, au moins une zone (13) dotée d'un diamètre libre se rétrécissant.

9. Microscope électronique (1) selon une des revendications 1 à 8, **caractérisé en ce qu'**il est prévu un second écran de limitation de pression (15) qui est disposé à une extrémité supérieure de la colonne électronique (4), la source d'électrons (2) étant disposée à l'extérieur de la colonne électronique (4) dans une chambre pouvant être mise sous vide (16) séparément de celle-ci.

10. Microscope électronique (1) selon une des revendications 1 à 9, **caractérisé en ce qu'**il est prévu au moins une pompe à vide (17) grâce à laquelle, en cas de pression atmosphérique simultanée dans la chambre à échantillon (5), une pression dans la colonne électronique (4) peut être abaissée jusqu'à un vide poussé, en particulier jusqu'à un ultravide, l'écran (8) étant réalisé de manière à ce qu'une transition de pression se produise par à-coups.

11. Utilisation d'un microscope électronique (1) selon une des revendications 1 à 10, destiné à l'analyse d'un échantillon en particulier humide et/ou biologique (7) sous pression atmosphérique et/ou à température ambiante.

12. Procédé d'analyse d'un échantillon (7) avec un microscope électronique (1), dans lequel est générée par une source d'électrons (2) un rayon électronique (3) qui est conduit à travers une colonne électronique (4) et au moins un écran de limitation de pression (8) vers l'échantillon (7) disposé dans une chambre à échantillon (5) sur une table à échantillon (6) et par lequel des électrons secondaires et des électrons de rétrodiffusion sont générés, les électrons à basse énergie (10) étant détectés par un détecteur (9) disposé dans la chambre à échantillon, **caractérisé en ce que** le rayon électronique (3) est conduit par une colonne électronique (4) d'un diamètre (11) libre constant le long de son axe longitudinal (X) ou se rétrécissant en direction de la chambre à échantillon (5) vers l'échantillon (7) et qui est déplacée par rapport à la table à échantillon (6) est indépendamment du détecteur (9), afin d'analyser l'échantillon (7) de préférence sous pression atmosphérique et/ou à température ambiante.

13. Procédé selon la revendication 12, **caractérisé en ce que** les électrons à basse énergie (10) sont détectés par un détecteur (9) réalisé sous forme d'un détecteur à aiguille doté d'un rayon de pointe prédéfini, dissocié de l'écran de limitation de pression (8) et disposé en-dessous de celui-ci.

14. Procédé selon la revendication 12 ou 13, **caractérisé en ce qu'**une chambre du détecteur (12) est mise sous vide séparément pour stocker le détecteur (9).

15. Procédé selon une des revendications 12 à 14, **caractérisé en ce que** la table à échantillon (6) est déplacée avec l'échantillon (7) jusqu'à une distance prédéfinie par rapport à l'écran de limitation de pression (8).
